# FASCICULE DE BREVET EUROPEEN

(11) **EP 3 214 664 B1**
(45) Date de publication et mention de la délivrance du brevet: **15.08.2018**
(21) Numéro de dépôt: 17158872.6
(22) Date de dépôt: 02.03.2017
(51) Int. Cl.: H01L 45/00

(54) **STRUCTURE DE COMMUTATEUR COMPORTANT PLUSIEURS CANAUX DE MATERIAU A CHANGEMENT DE PHASE ET ELECTRODES DE COMMANDE INTERDIGITEES**
SCHALTSTRUKTUR MIT MEHREREN PHASENÄNDERUNGSMATERIALKANÄLEN UND INTERDIGITALKONTROLLELEKTRODEN
SWITCH STRUCTURE HAVING MULTIPLE PHASE CHANGE MATERIAL CHANNELS AND INTERDIGITATED CONTROL ELECTRODES

(30) Priorité: 02.03.2016 FR 1651778
(43) Date de publication de la demande: 06.09.2017
(73) Titulaire: COMMISSARIAT À L'ÉNERGIE ATOMIQUE ET AUX ÉNERGIES ALTERNATIVES, 75015 Paris (FR)
(72) Inventeur: REIG, Bruno, 38430 MOIRANS (FR); LEON, Alexandre, 38360 SASSENAGE (FR); NAVARRO, Gabriele, 38000 GRENOBLE (FR); PUYAL, Vincent, 38000 GRENOBLE (FR); SAINT-PATRICE, Damien, 26120 CHABEUIL (FR)
(74) Mandataire: Brevalex

(56) Documents cités:
- WO-A1-2009/001262
- US-A1- 2007 099 405
- US-A1- 2014 266 517
- US-A1- 2016 003 573

## Description

### DOMAINE TECHNIQUE ET ART ANTÉRIEUR

La présente demande se rapporte au domaine des commutateurs intégrant un matériau à changement de phase en particulier à ceux réalisés en couches minces et qui peuvent faire partie d'un circuit intégré ou d'un dispositif électronique. La présente invention s'applique notamment aux commutateurs RF, c'est-à-dire aux structures destinées à modifier de manière réversible les connexions électriques entre des éléments d'un circuit RF.

Les commutateurs RF sont habituellement réalisés à partir de composants électroniques tels que les transistors à effet de champ (FET pour « Field Effect Transistor ») ou les diodes PIN (pour « Positive Intrinsic Negative ») ou à l'aide de relais électro-mécaniques de type MEMS (pour « Micro Electro Mechanical System »).

Des commutateurs RF intégrant un matériau à changement de phase (PCM pour « Phase Change Material ») sont également apparus.

Le fonctionnement d'un commutateur RF à base de matériau PCM s'appuie typiquement sur deux états que ce matériau est susceptible d'adopter :
- un état amorphe à haute résistivité, qui est assimilé à un état bloqué du commutateur lors duquel on empêche la transmission d'un signal RF entre au moins deux bornes,
- un état cristallin à faible résistivité, qui constitue un état passant du commutateur lors duquel on permet la transmission du signal RF entre les deux bornes.

Les deux états étant stables, il n'est pas nécessaire de maintenir un courant/tension pour maintenir un état ce qui permet une économie de puissance en comparaison d'autres technologies tels que les commutateurs à base de FET ou de diode PIN.

Par ailleurs, un commutateur doté d'un matériau PCM permet d'acheminer des signaux de puissance plus importante par rapport à ceux habituellement véhiculés par les commutateurs MEMS.

Le document US 2014/0266517 A1, prévoit un exemple d'interrupteur doté d'un matériau PCM inséré entre une ligne conductrice d'entrée et une ligne conductrice de sortie par lesquelles un signal RF est destiné à transiter.

Le changement de phase du matériau PCM est obtenu en faisant passer une impulsion de courant dans des électrodes de commande dédiées disposées en contact direct avec le matériau PCM ou bien à distance de ce dernier. Avec un tel type de dispositif, il peut s'avérer difficile d'obtenir un changement de phase homogène du matériau PCM sur toute sa surface, d'autant que pour obtenir une bonne isolation à l'état bloqué et une faible résistance à l'état passant on ne peut généralement pas trop réduire la surface de matériau PCM. Un autre dispositif du même type est divulgué dans le document US2007/0099405A1.

Lorsqu'une cristallisation ou une amorphisation incomplète du matériau PCM se produit, les états « bloqué » et « passant » de l'interrupteur sont mal définis. Plus généralement, l'inhomogénéité de changement de phase peut entraîner une dégradation des performances de l'interrupteur voire une défaillance de ce dernier.

### EXPOSÉ DE L'INVENTION

Un mode de réalisation de la présente invention concerne un dispositif apte à établir ou rompre une connexion entre un premier élément conducteur et un deuxième élément conducteur reposant sur un support, ledit dispositif comprenant :
- au moins un matériau à changement de phase disposé entre le premier élément conducteur et le deuxième élément conducteur, le matériau à changement de phase étant apte à changer d'état entre un état cristallin dans lequel le matériau à changement de phase a une première résistivité et un état amorphe dans lequel le matériau à changement de phase a une deuxième résistivité plus importante que la première résistivité, de telle sorte que lorsque le matériau à changement de phase est dans l'état cristallin il permet l'acheminement d'un premier signal entre le premier élément conducteur et le deuxième élément conducteur, lorsque le matériau à changement de phase est dans l'état amorphe il empêche l'acheminement du premier signal entre le premier élément conducteur et le deuxième élément conducteur,
- des moyens de chauffage du matériau à changement de phase dotés d'au moins une première électrode et d'au moins une deuxième électrode, les moyens de chauffage étant aptes à modifier l'état du matériau à changement de phase par injection d'au moins un signal électrique d'activation à la première électrode et/ou la deuxième électrode, au moins une électrode donnée parmi lesdites première électrode et deuxième électrode comportant au moins une partie portion conductrice disposée entre le premier élément conducteur et le deuxième élément conducteur, des zones du matériau à changement de phase étant agencées entre le premier élément conducteur et le deuxième élément conducteur et étant disposées de part et d'autre de cette portion conductrice.

Un autre mode de réalisation de la présente invention concerne un dispositif apte à acheminer ou à interrompre une connexion entre au moins un premier élément conducteur et au moins un deuxième élément conducteur reposant sur un support, ledit dispositif comprenant :
- au moins un matériau à changement de phase disposé entre le premier élément conducteur et le deuxième élément conducteur, le matériau à changement de phase étant apte à changer d'état entre un état cristallin dans lequel le matériau à changement de phase a une première résistivité et un état amorphe dans lequel le matériau à changement de phase a une deuxième résistivité plus importante que la première résistivité, de telle sorte que lorsque le matériau à changement de phase est dans l'état cristallin il permet l'acheminement d'un premier signal entre le premier élément conducteur et le deuxième élément conducteur, lorsque le matériau à changement de phase est dans l'état amorphe il empêche l'acheminement du premier signal entre le premier élément conducteur et le deuxième élément conducteur,
- des moyens de chauffage du matériau à changement de phase dotés d'au moins une première électrode et d'au moins une deuxième électrode, les moyens de chauffage étant aptes à modifier l'état du matériau à changement de phase par effet Joule en injectant au moins un signal électrique d'activation entre la première électrode et la deuxième électrode,
le dispositif comportant, entre le premier élément conducteur et le deuxième élément conducteur :
- au moins une première zone de matériau à changement de phase et une au moins une deuxième zone de matériau à changement de phase, la première zone de matériau à changement de phase et la deuxième zone de matériau à changement de phase étant disposées de part et d'autre et en contact d'une portion conductrice d'une électrode donnée parmi lesdites première électrode et deuxième électrode, la première zone de matériau à changement de phase étant intercalée entre ladite portion conductrice de l'électrode donnée et une portion conductrice d'une autre électrode parmi lesdites première électrode et deuxième électrode, la deuxième zone de matériau à changement de phase étant intercalée entre ladite portion conductrice de l'électrode donnée et une portion conductrice d'une autre électrode parmi lesdites première électrode et deuxième électrode.

Par acheminement du premier signal entre le premier élément conducteur et le deuxième élément conducteur, on entend du premier élément conducteur vers le deuxième élément conducteur ou du deuxième élément conducteur vers le premier élément conducteur.

Avec un tel agencement du matériau à changement de phase par rapport à la partie conductrice de l'électrode donnée des moyens de chauffage, et en particulier une répartition du matériau à changement de phase (PCM) en plusieurs zones distinctes ou parcelles, on permet de rendre plus homogène le changement d'état de ce matériau, et en particulier d'homogénéiser l'amorphisation de ce matériau.

On commande le changement de phase de ces parcelles de matériau PCM par des électrodes dissociées des éléments conducteurs destinés à acheminer le premier signal.

Le matériau à changement de phase peut être ainsi disposé selon au moins deux zones de PCM réparties contre les électrodes des moyens de chauffage et orientées selon la direction de transmission du signal entre les éléments conducteurs.

Une mise en parallèle des parcelles ou zones de matériau à changement de phase permet d'avoir une faible résistance dans l'état passant.

Le dispositif peut être un commutateur RF ou un interrupteur bistable RF.

Le signal électrique d'activation peut être en particulier sous forme d'au moins une impulsion de courant appliquée à l'une des électrodes et destinée à traverser le matériau à changement de phase.

Avantageusement, le premier élément conducteur et le deuxième élément conducteur peuvent être disposés dans un même premier plan. Une telle configuration permet de pouvoir éventuellement séparer le premier élément conducteur et le deuxième élément conducteur d'une distance importante afin de diminuer la capacité entre le premier élément conducteur et le deuxième conducteur et obtenir également une meilleure isolation. La réalisation du premier élément conducteur et du deuxième élément conducteur dans un même plan (structure « in-line ») permet d'obtenir un meilleur blocage du premier signal dans l'état non passant qu'avec une structure empilée.

Lesdites portions conductrices peuvent être agencées orthogonalement au plan principal du support. Ainsi, le signal d'activation du matériau PCM est susceptible de circuler dans une direction orthogonale à la direction d'acheminement du premier signal entre les éléments conducteurs. Un tel agencement de la première électrode et/ou de la deuxième électrode permet de disposer les électrodes des moyens de chauffage dans un plan différent de celui dans lequel se trouvent le premier élément conducteur et le deuxième élément conducteur, ce qui permet notamment de pouvoir réduire les risques de couplage entre électrodes et éléments conducteur dédiés à l'acheminement du premier signal.

Les électrodes peuvent être munies d'une pluralité de pistes conductrices chacune formée d'une portion conductrice verticale et d'une zone conductrice horizontale.

Avantageusement, la première électrode comporte plusieurs premières pistes conductrices tandis que la deuxième électrode comporte plusieurs deuxièmes pistes conductrices, les premières pistes conductrices et les deuxièmes pistes conductrices étant interdigitées. Avantageusement, la première électrode comporte une pluralité de portions conductrices verticales et la deuxième électrode comporte une pluralité de portions conductrices verticales, les portions conductrices verticales de la première électrode et les portions conductrices verticales de la deuxième électrode étant interdigitées.

Cela permet d'améliorer davantage l'homogénéisation de l'état du matériau à changement de phase. Une structure d'électrodes avec plusieurs pistes conductrices permet également de prévoir des zones de PCM ayant un rapport de forme (longueur/largeur) favorable au changement de phase complet en particulier lors de l'amorphisation.

Selon une possibilité de mise en oeuvre, on prévoit lesdites zones du matériau à changement de phase situées de part et d'autre de la partie conductrice avec une longueur L' et une largeur W' telles que L'/W' supérieur à 1 et de préférence supérieur à 3. Un tel rapport de forme est favorable au changement d'état complet du matériau à changement de phase.

La première électrode et la deuxième électrode peuvent être en contact avec lesdites zones de matériau à changement de phase et former ainsi un moyen de chauffage direct du matériau à changement de phase.

Selon une possibilité de mise en oeuvre, les moyens de chauffage peuvent comprendre en outre au moins un moyen de chauffage supplémentaire.

Ce moyen de chauffage supplémentaire peut être un moyen de chauffage indirect du matériau à changement de phase configuré pour chauffer le matériau à changement de phase par radiation thermique. Le moyen de chauffage indirect peut comprendre une résistance connectée à au moins une électrode supplémentaire par laquelle un autre signal électrique d'activation est destiné à être appliqué. Le contrôle par un moyen de chauffage indirect du passage de l'état amorphe à l'état cristallin par une résistance déportée permet d'avoir une cristallisation uniforme sur des largeurs combinées importantes de matériau PCM. Cela permet d'optimiser la transmission du premier signal dans l'état passant du dispositif.

L'autre signal électrique d'activation peut être un courant injecté en particulier sous forme d'au moins une impulsion typiquement d'amplitude plus faible que celle injectée à l'électrode donnée du moyen de chauffage direct.

Avantageusement, l'électrode supplémentaire peut être disposée dans le premier plan. Cela permet notamment de définir les motifs d'électrode du moyen de chauffage direct en même temps que les éléments conducteurs.

Selon une possibilité de mise en oeuvre, les moyens de chauffage peuvent être prévus pour alternativement :
- injecter ledit signal électrique d'activation à l'électrode donnée de sorte à faire passer le matériau à changement de phase d'un état cristallin à un état amorphe,
- injecter ledit autre signal électrique d'activation à l'électrode supplémentaire de sorte à faire passer le matériau à changement de phase d'un état amorphe à un état cristallin. Dans ce cas, l'amorphisation du matériau PCM qui nécessite une température élevée est réalisée par chauffage direct et la cristallisation qui nécessite moins de puissance est réalisée par chauffage indirect. La consommation de puissance DC est donc réduite en comparaison des structures connues utilisant un chauffage uniquement indirect.

En variante, les moyens de chauffage peuvent être configurés pour injecter le signal électrique d'activation à l'électrode donnée et injecter concomitamment l'autre signal d'activation à l'électrode supplémentaire.

Pour empêcher un couplage entre les électrodes et les éléments conducteurs et éviter que le signal d'activation ne soit transmis aux éléments conducteurs, le premier élément conducteur et/ou le deuxième élément conducteur peut être connecté à un moyen de découplage tel qu'un condensateur de découplage.

Pour éviter que le premier signal ne soit transmis aux électrodes, la première électrode et/ou la deuxième électrode peut être connectée à un moyen de découplage telle qu'une inductance de découplage.

Pour éviter que le premier signal ne soit transmis à une électrode supplémentaire du moyen de chauffage indirect, cette électrode supplémentaire peut être connectée à un moyen de découplage telle qu'une inductance de découplage.

Selon un mode de réalisation, le dispositif peut comporter des zones de matériaux à changement de phase différents entre le premier élément conducteur et le deuxième élément conducteur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un exemple de dispositif commutateur RF ou interrupteur RF mis en oeuvre suivant un mode de réalisation de la présente invention doté d'un matériau PCM intégré, le dispositif étant représenté selon une vue en perspective ;
- la figure 2 donne une vue de dessus du dispositif;
- la figure 3 donne une vue agrandie de portions conductrices d'électrodes servant à chauffer le matériau PCM ;
- la figure 4 donne une vue de dessus d'une parcelle de matériau PCM ;
- la figure 5 donne une vue schématique simplifiée de dessus de parcelles de matériau PCM intercalées entre des portions d'électrodes de moyens de chauffage du matériau PCM ;
- les figures 6A-6C servent à illustrer différents exemples de moyens de découplage pour permettre un découplage entre d'une part le ou les signaux de commande de l'interrupteur ou commutateur et d'autre part le signal destiné à être transmis par ce commutateur ou interrupteur ;
- les figures 7A-7F servent à illustrer un exemple de procédé de fabrication du dispositif commutateur ou interrupteur ;

En outre, dans la description ci-après, des termes qui dépendent de l'orientation du dispositif s'appliquent en considérant que la structure est orientée de la façon illustrée sur les figures.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

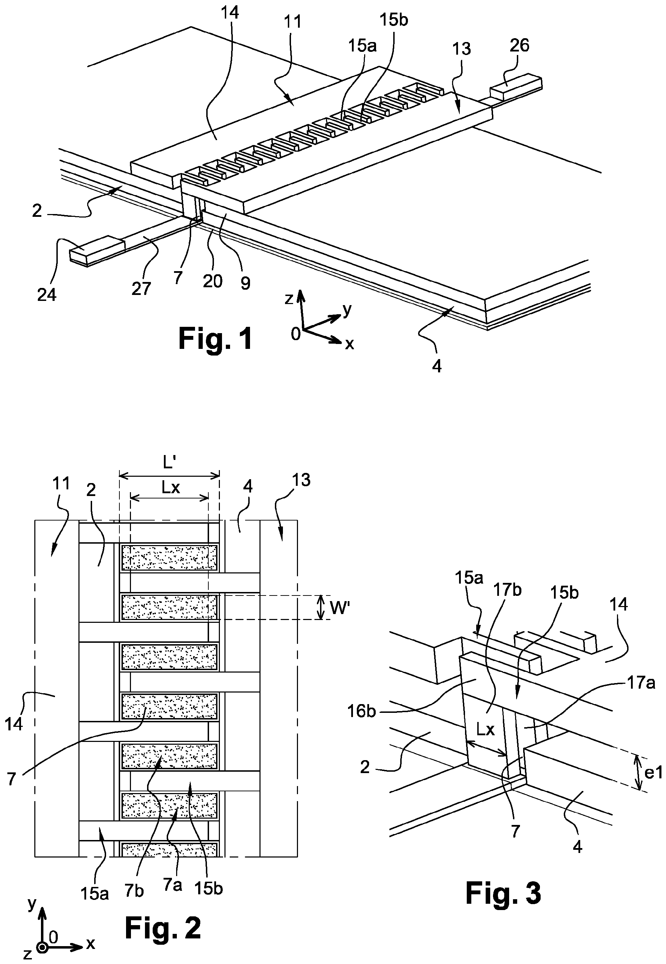

On se réfère tout d'abord aux figures 1, 2, 3 illustrant de manière schématique (respectivement selon une vue en perspective, une vue de dessus, et une région agrandie de la vue en perspective) un exemple de dispositif selon un mode de réalisation de la présente invention.

Ce dispositif est un commutateur permettant de modifier les connexions d'au moins un circuit (non représenté) qui, dans cet exemple de réalisation, est destiné à véhiculer des signaux radio-fréquences (RF). Le commutateur est ainsi un commutateur RF apte à acheminer ou à interrompre l'acheminement d'au moins un signal RF entre une première portion de circuit et une deuxième portion de circuit, en fonction de l'état d'au moins un matériau à changement de phase (PCM) agencé entre ces deux portions. Le dispositif décrit ici peut remplir la fonction d'un interrupteur bistable. On utilisera néanmoins le terme « commutateur » tout au long du présent exposé détaillé.

Le signal RF véhiculé a une fréquence qui peut être comprise par exemple entre plusieurs mégahertz et plusieurs centaines de gigahertz et une puissance par exemple de l'ordre de 40 dBm.

Le commutateur comporte ainsi un premier élément conducteur 2 par lequel au moins un signal RF est destiné à entrer et qui est connecté avec la première portion de circuit RF et un deuxième élément conducteur 4 connecté avec la deuxième portion du circuit RF et par lequel le signal RF est ainsi destiné à sortir. Le premier élément conducteur 2 et le deuxième élément conducteur 4 forment ainsi deux terminaisons d'une ligne de transmission de signal électrique RF, ces deux terminaisons étant séparées l'une de l'autre par un matériau à changement de phase 7 et étant connectées électriquement à, et avantageusement en contact avec, ce matériau à changement de phase 7. Le premier élément conducteur 2 et le deuxième élément conducteur 4 peuvent être par exemple à base d'un matériau métallique tel que de l'aluminium (Al), du cuivre (Cu), de l'or (Au), du titane (Ti), ou du tungstène (W) ou d'un matériau semi-conducteur dopé tel que par exemple du silicium dopé, ou d'un polymère conducteur tel que le PEDOT (3,4-éthylènedioxythiophène), ou d'un oxyde métallique tel que de l'oxyde de ruthénium (RuO₂) ou de l'oxyde d'iridium (IrO₂), ou d'un matériau conducteur transparent tel que par exemple de l'ITO (oxyde d'indium dopé à l'étain).

Le premier élément conducteur 2 et le deuxième élément conducteur 4 sont ici par exemple sous forme de zones conductrices planes qui s'étendent sur un support, et en particulier parallèlement au plan principal de ce support. Par « plan principal » du support, on entend un plan passant par le support et qui est parallèle au plan [0 ; x ; y] du repère orthogonal [0 ; x ; y ; z] indiqué sur les figures 1 et 2.

Le support peut être un substrat, en particulier un substrat semi-conducteur, par exemple à base de silicium, éventuellement revêtu d'une couche de passivation en oxyde de silicium (SiO₂). En variante, le support du commutateur peut être un dispositif microélectronique, en particulier une couche isolante de ce dispositif. On peut ainsi prévoir comme support un couche isolante par exemple de type IMD pour (« Intermetal dielectric layer ») et qui est située entre deux niveaux d'interconnexions de composants électroniques ou bien une couche isolante appartenant à un des niveaux finaux communément appelés de « back-end » d'un circuit intégré.

Le commutateur est susceptible d'adopter un premier état appelé état « passant » dans lequel le premier élément conducteur 2 et le deuxième élément conducteur 4 sont connectés l'un à l'autre de sorte qu'au moins un signal RF peut transiter du premier élément conducteur 2 au deuxième élément conducteur 4. Le commutateur est également susceptible d'adopter un deuxième état appelé état « bloqué » dans lequel entre le premier élément conducteur 2 et le deuxième élément conducteur 4, la transmission d'un signal RF entre le premier élément conducteur 2 et le deuxième élément conducteur 4 est empêchée.

Les états « passant » et « bloqué » du commutateur correspondent à différents états du matériau 7 à changement de phase. Le matériau 7 à changement de phase peut être en particulier un matériau apte à passer d'un état amorphe à un état cristallin et inversement en fonction de la température à laquelle celui-ci est porté. Ainsi, ce matériau 7 à changement de phase intercalé entre les éléments conducteurs 2, 4 est susceptible, lorsqu'il est sous forme amorphe, d'adopter un état de forte résistivité, et lorsqu'il se trouve sous forme cristalline, d'adopter un état de faible résistivité. Par « faible résistivité » on entend une résistivité qui peut être comprise par exemple entre 10⁻⁴ ohm.cm et 10⁻² ohm.cm. Par « forte résistivité », on entend une résistivité qui peut être comprise par exemple entre 10 ohm.cm à 1000 ohm.cm.

Lorsque le matériau à changement de phase 7 est dans son état cristallin faiblement résistif, le signal RF est transmis du premier élément conducteur 2 vers le deuxième élément conducteur 4 tandis que lorsque le matériau à changement de phase 7 est dans son état amorphe fortement résistif, le signal RF est réfléchi et n'est donc pas transmis vers le deuxième élément conducteur 4. En changeant l'état du matériau entre son état amorphe et son état cristallin on peut donc obtenir une fonction d'interrupteur.

Le matériau 7 à changement de phase peut être par exemple à base d'un chalcogénure ou d'un alliage de chalcogénures comme du Ge₂Sb₂Te₅ ou du GeTe. De tels matériaux ont avantageusement un rapport de résistivité élevé, par exemple de l'ordre de 10³ et qui peut atteindre 10⁶ entre leur état de faible résistivité et leur état de forte résistivité.

Pour faire passer le matériau à changement de phase 7 d'un état cristallin à un état amorphe et inversement, le dispositif est doté de moyens d'activation du matériau PCM 7, ces moyens étant ici des moyens de chauffage de préférence de type électrique.

Pour faire passer le matériau à changement de phase 7 d'un état cristallin à un état amorphe du matériau PCM 7, celui-ci est chauffé à une température située dans une première gamme de températures, en particulier des températures élevées pendant une première durée, typiquement courte. La première gamme de températures peut être comprise entre par exemple 600°C et 1000°C, appliquée pendant une durée comprise entre 10 ns à 100 ns en particulier lorsque le matériau à changement de phase 7 est par exemple du Ge₅₀Te₅₀ ou du Ge₃₀Te₇₀ ou du Ge₂Sb₂Te₅. Les températures de cette première gamme peuvent être ainsi situées au-delà de la température de fusion T_{F} du matériau à changement de phase, qui est par exemple de l'ordre de 725°C pour le GeTe.

Pour faire passer le matériau à changement de phase 7 d'un état amorphe à un état cristallin du matériau PCM 7, celui-ci est chauffé à une température située dans une deuxième gamme de températures, en particulier des températures plus faibles que la première gamme, pendant une première durée typiquement plus longue que les durées d'amorphisation. Celui-ci peut être ainsi mis à une autre température située dans une deuxième gamme de températures, plus faible que la première gamme pour retrouver son état cristallin. Les températures de cette deuxième gamme sont typiquement supérieures à la température de cristallisation du matériau PCM 7 (par exemple de l'ordre de 190°C pour le GeTe) et inférieures à la température de fusion T_{F} de ce matériau à changement de phase (par exemple de l'ordre de 725°C pour le GeTe). Lorsque le matériau PCM 7 est du GeTe, celui-ci peut retrouver un état cristallin en étant chauffé à une température comprise typiquement entre 150°C et 250°C. Plus la température est proche de la température de fusion, plus la recristallisation sera rapide. L'utilisation d'un matériau type GeTe avec une vitesse de croissance très élevée peut garantir une vitesse de recristallisation rapide. Typiquement, la durée pour revenir de l'état amorphe à l'état cristallin est plus importante que celle pour passer de l'état cristallin à l'état amorphe, par exemple entre 1 µs et 10 ms. Les températures appliquées et durées respectives d'application dépendent du matériau à changement de phase 7 que l'on choisit.

Pour chauffer le matériau PCM 7 et le faire changer d'état on peut prévoir un moyen de chauffage direct configuré pour injecter un signal d'activation électrique, par exemple sous forme d'un courant dans le matériau PCM 7 qui est alors chauffé par effet joule. Le moyen de chauffage direct est doté d'électrodes 11, 13 entre lesquelles le matériau PCM 7 est disposé.

Lorsqu'une impulsion de courant appropriée passe entre les deux électrodes 11 et 13 à travers le matériau 7 PCM, ce matériau passe d'un état cristallin à un état amorphe fortement résistif. On bloque alors le passage d'un signal RF entre le premier élément conducteur 2 et le deuxième élément conducteur 4. Pour faire passer le matériau 7 PCM de son état amorphe à son état cristallin, on applique une autre impulsion de courant appropriée entre les deux électrodes 11, 13 à travers le matériau 7 PCM.

L'impulsion de courant peut avoir une intensité entre plusieurs centaines de micro-ampères et plusieurs dizaines de mA suivant la quantité de matériau PCM. On peut par exemple prévoir des impulsions de l'ordre de 1 mA et d'une durée de l'ordre de 10 µs pour effectuer une cristallisation, tandis que pour réaliser une amorphisation, les impulsions de courant ont une intensité plus importante, par exemple de l'ordre de 10 mA et une durée plus courte, par exemple de l'ordre de 50 ns.

On fait alors passer le signal RF entre le premier élément conducteur 2 et le deuxième élément conducteur 4. Le signal électrique d'activation (par exemple un courant) appliqué pourfaire passer le matériau PCM 7 d'un état cristallin à un état amorphe est prévu avec une amplitude (intensité) supérieure à celle du signal appliqué pour faire passer le matériau PCM 7 d'un état amorphe à un état cristallin.

Les électrodes 11, 13 peuvent avoir par exemple une forme de peignes et comprendre des zones conductrices planes 14 par exemple de forme rectangulaire auxquelles sont rattachées des pistes conductrices 15a, 15b d'extrémités qui forment les dents du peigne. Les pistes conductrices 15a d'extrémités de la première électrode 11 s'étendent en direction de la deuxième électrode 13, tandis que les pistes conductrices 15b d'extrémités de la deuxième électrode 13 s'étendent en direction de la première électrode 11. Les pistes conductrices de chacune des électrodes peuvent être parallèles entre elles et interdigitées avec celles de l'autre électrode.

Les électrodes 11, 13 du moyen de chauffage direct sont de préférence dissociées des éléments conducteurs 2, 4 par lequel le signal RF transite. La paire d'éléments conducteurs 2, 4 peut être ainsi isolée de celle d'électrodes 11, 13 par le biais d'au moins une couche diélectrique 9 intermédiaire, par exemple à base de nitrure de silicium d'épaisseur e₁ (mesurée parallèlement à l'axe z du repère orthogonal [0 ; x ; y ; z]) par exemple de l'ordre de 100 nm. Un tel agencement permet de mieux dissocier le chemin de signaux RF de celui d'un courant DC entre les électrodes 11, 13. Il est ainsi possible d'éviter la création d'un chemin électrique entre éléments conducteurs 2, 4 et électrodes 11, 13 de chauffage direct lorsqu'on active le changement d'état du matériau PCM 7.

Dans cet exemple de réalisation, les pistes conductrices 15a, 15b d'extrémité sont formées de zones horizontales 16a (pour la première électrode), 16b (pour la deuxième électrode), les zones conductrices horizontales 16a de la première électrode 11 s'étendant vers la deuxième électrode 13, tandis que les zones conductrices horizontales 16b de la deuxième électrode 13 s'étendent vers la première électrode 11.

Dans l'exemple de réalisation des figures 1 et 2, les électrodes 11, 13 ne sont pas disposées au même niveau que les éléments conducteurs 2, 4. Le matériau à changement de phase 7 est quant à lui situé au même niveau que les éléments conducteurs 2, 4 véhiculant le signal RF, tandis que les électrodes 11, 13 sont placées au-dessus des éléments conducteurs 2, 4.

Pour permettre une prise de contact entre les électrodes 11, 13 du moyen de chauffage direct (situé au-dessus des éléments conducteurs 2, 4) et le matériau à changement de phase 7, les pistes conductrices 15a, 15b d'extrémité sont dotées de portions conductrice verticale 17a (pour la première électrode 11) et 17b (pour la deuxième électrode 13) chaque portion conductrice verticale 17a (resp. 17b) étant située dans le prolongement d'une zone conductrice horizontale 16a (resp. 16b).

Les portions 17a ou 17b conductrices verticales s'étendent typiquement orthogonalement au support autrement dit parallèlement à l'axe z du repère [0 ; x ; y ; z] et sont en contact avec les zones de matériau PCM sur une longueur Lx plus petite que la longueur L' des zones de PCM (les longueurs Lx et L' étant mesurées parallèlement à l'axe x du repère orthogonal [0 ; x ; y ; z]).

Pour permettre de mieux contrôler les changements d'états du matériau PCM 7 et assurer un changement d'état plus homogène du matériau à changement de phase 7, en particulier pouvoir obtenir un état amorphe complet du matériau à changement de phase 7, on prévoit un agencement amélioré des électrodes 11, 13 et du matériau à changement de phase 7 l'un par rapport à l'autre.

Le matériau PCM 7 est ainsi réparti en plusieurs zones 7a, 7b, également appelées « parcelles » disposées en parallèle entre le premier élément conducteur 2 par lequel un signal RF est destiné à entrer et le deuxième élément conducteur 4 par lequel le signal RF est destiné à sortir. Cette disposition en parcelles ou zones 7a, 7b, de matériau PCM permet d'avoir une faible résistance à l'état passant du commutateur. De préférence, on prévoit les zones 7a, 7b, ou parcelles 7a, 7b, de matériau PCM 7 avec un rapport de forme L'/W' entre leur longueur L' et leur largeur W' (mesurée parallèlement à l'axe y du repère orthogonal [0 ; x ; y ; z]) supérieur à 1 et qui est avantageusement supérieur à 3, afin d'améliorer l'homogénéité de cristallisation et d'amorphisation par chauffage direct du matériau PCM. En phase amorphe hautement résistive la conductivité peut être par exemple de l'ordre de 1S/m ce qui permet d'obtenir des résistances de l'ordre de 100 kΩ à 1 MΩ pour une zone de matériau PCM d'une longueur L' de l'ordre de 1 µm, une largeur combinée (somme des largeurs W') des parcelles de l'ordre d'une dizaine de microns et une épaisseur de l'ordre d'une centaine de nanomètres. La conductivité lors de la phase cristalline est typiquement de l'ordre de 100 kS/m, ce qui permet d'obtenir des résistances de l'ordre de 1 Ω.

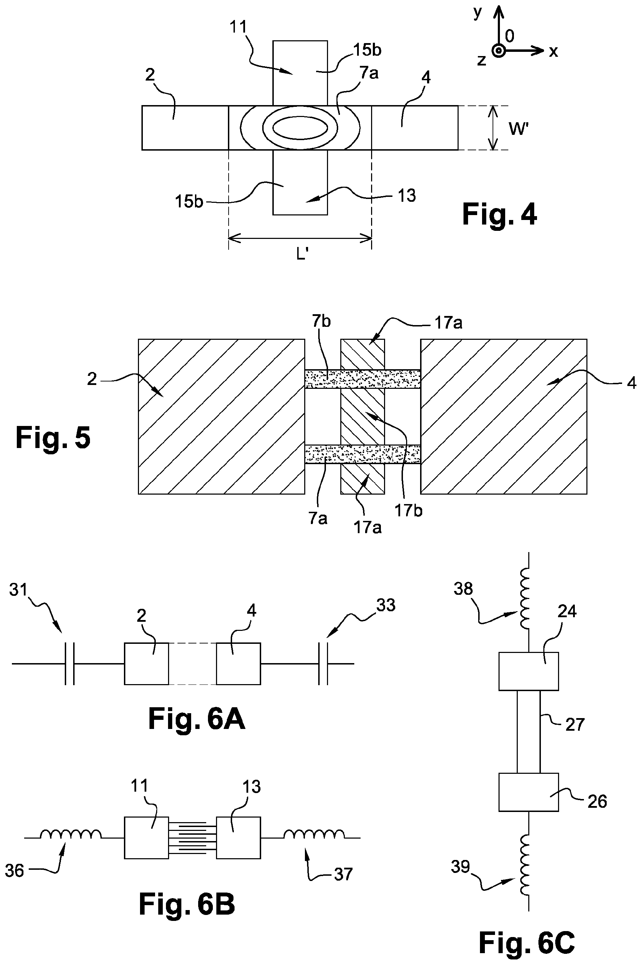

Les portions conductrices verticales 17a, 17b qui s'étendent contre les zones 7a, 7b ou parcelles 7a, 7b de matériau PCM, peuvent être avantageusement disposées de sorte qu'une portion conductrice 17a de la première électrode 11, et une portion conductrice 17b de la deuxième électrode 13, sont situées de part et d'autre et en contact d'une zone ou parcelle de matériau PCM (figure 4).

La figure 5 donne une vue de dessus dans le plan des éléments conducteurs 2, 4 d'un exemple d'agencement de zones ou parcelles 7a, 7b de matériau PCM par rapport à des portions conductrices verticales d'électrodes de chauffage 11, 13.

Une première zone 7a de matériau à changement de phase et une deuxième zone 7b de matériau à changement de phase sont disposées de part et d'autre d'une portion conductrice 17b de la deuxième électrode 13, la première zone 7a de matériau à changement de phase étant intercalée entre cette portion conductrice 17b de la deuxième électrode 13 et une portion conductrice 17a de la première électrode 11. De même, la deuxième zone de matériau à changement de phase 7b est intercalée entre la portion conductrice 17b de la deuxième électrode 13 et une portion conductrice 17a de la première électrode 11. Les pistes conductrices 17a, 17b, sont ici en contact direct avec les zones de matériau à changement de phase.

Ainsi, dans un plan parallèle au plan principal du support et une direction réalisant un angle non-nul, en particulier orthogonale, avec les parties horizontales 15a des pistes conductrices 15, le commutateur comporte une alternance de pistes conductrices 15a, 5b et de zones 7a, 7b de matériau à changement de phase 7. Avantageusement, les pistes conductrices 15a de la première électrode 11 et les pistes conductrices 15b de la seconde électrode 13 sont interdigitées. Pour passer de l'état cristallin à l'état amorphe, on fait passer un courant entre les électrodes 11, 13 en peignes interdigités directement au travers des parcelles du matériau PCM grâce aux portions verticales 17a, 17b des pistes conductrices 15a, 15b formant les dents des peignes qui sont en contact avec les parcelles de PCM.

L'agencement des pistes conductrices 15a, 15b des électrodes 11, 13, situées de part et d'autre des zones ou parcelles de matériau 7 PCM, permet d'assurer une meilleure uniformité ou homogénéité du changement de phase de la zone de matériau 7 PCM, ce qui permet également d'avoir une meilleur définition des états « passant » ou « bloqué » du commutateur.

Afin d'améliorer les changements d'état du matériau PCM, et en particulier faciliter le passage du matériau 7 PCM d'un état amorphe à un état cristallin, le commutateur peut être également doté d'un moyen de chauffage supplémentaire, appelé moyen de chauffage « indirect » dans la mesure où il n'est pas disposé en contact direct avec le matériau 7 à changement de phase.

Le moyen de chauffage indirect peut être muni d'électrodes supplémentaires 24, 26 disposées de part et d'autre des éléments conducteurs 2, 4 et des électrodes 11, 13. Les électrodes supplémentaires 24, 26 forment des terminaisons du moyen de chauffage indirect utilisé. Ces deux terminaisons sont disposées sur une couche mince formant une résistance 27. Cette résistance 27 peut être à base d'un matériau conducteur ayant une résistivité élevée, par exemple comprise entre 100 µΩ.cm et 1000 µQ.cm.

La résistance 27 peut être disposée à proximité du matériau 7 PCM et être électriquement isolée de ce matériau 7 PCM par un matériau diélectrique 20. Dans l'exemple de réalisation particulier de la figure 1, la résistance 27 s'étend sous le matériau 7 à changement de phase. Lorsqu'une impulsion de courant appropriée passe entre les deux électrodes 24 et 26 à travers la résistance 27, une radiation thermique générée par effet Joule permet de chauffer le matériau 7 PCM à travers le matériau diélectrique 20 et est susceptible de faire passer le matériau PCM 7 de son état amorphe à son état cristallin faiblement résistif. L'impulsion de courant mise en oeuvre peut avoir une intensité de l'ordre de 10 fois celle des impulsions produites pour le chauffage direct.

Comme pour le chauffage direct, la durée des impulsions dépend de l'état dans lequel on souhaite placer le matériau PCM 7, des impulsions de durée plus importantes étant prévues pour rendre le matériau PCM amorphe que pour le rendre cristallin. Par exemple, des impulsions d'une durée de 10 ns à 100 ns peuvent être produites pour l'amorphisation du matériau PCM, tandis que des impulsions d'une durée comprise entre 1 µs et 1 ms vont être mises en oeuvre pour l'amorphisation du matériau PCM 7.

Une variante d'agencement prévoit de disposer directement la résistance 27 sur le matériau PCM 7 sans isolant intermédiaire.

Le moyen de chauffage indirect permet de produire une radiation thermique homogène de sorte à réaliser un chauffage homogène du matériau 7 à changement de phase. Cette uniformité de chauffage permet ainsi de cristalliser l'ensemble des zones 7a, 7b ou parcelles de matériau 7 PCM et d'avoir une faible résistance totale du matériau 7 PCM à l'état cristallin, qui peut être typiquement de l'ordre de 1 Ohm.

Avec un moyen de chauffage indirect, la zone de radiation thermique est ici définie par la taille de la résistance 27 et ne dépend plus de la répartition de la densité de courant dans le matériau PCM, ce qui rend l'homogénisation du changement d'état plus aisée.

La mise en oeuvre combinée d'un moyen de chauffage direct et d'un moyen de chauffage indirect permet d'atteindre les températures souhaitées dans le matériau 7 PCM sans devoir utiliser de trop fortes densités de courant. Par mise en oeuvre combinée on entend que le moyen de chauffage direct ou indirect peuvent agir simultanément ou successivement.

Ainsi, selon une possibilité de mise en oeuvre du moyen d'actionnement du matériau PCM 7, on prévoit que le déclenchement du changement d'état cristallin vers l'état amorphe de ce matériau à changement de phase 7 est réalisé à l'aide du moyen de chauffage direct lorsqu'un courant est injecté entre les électrodes 11 et 13, tandis que le déclenchement du changement d'état amorphe vers l'état cristallin du matériau à changement de phase 7 est effectué à l'aide du moyen de chauffage indirect lorsqu'un autre courant est injecté à une des électrodes 24, 26 supplémentaires. Par rapport à un dispositif qui n'utiliserait qu'un moyen de chauffage indirect, on diminue dans ce cas la puissance nécessaire pour atteindre l'état amorphe du matériau PCM 7.

Selon une autre possibilité de mise en oeuvre du moyen d'actionnement du matériau PCM 7, on prévoit que le déclenchement du changement d'état cristallin vers l'état amorphe de ce matériau à changement de phase 7 est réalisé par injection concomitante d'un courant issu du moyen de chauffage direct et d'un autre courant dans le moyen de chauffage indirect, tandis que le déclenchement du changement d'état amorphe vers l'état cristallin du matériau à changement de phase 7 est également effectué à l'aide du moyen de chauffage indirect et du moyen de chauffage direct.

Pour empêcher une transmission de signaux de commande des électrodes 11, 13 vers les éléments conducteurs 2, 4 destinés à véhiculer un signal RF ou pour empêcher une transmission de signal RF vers les électrodes 11, 13 sources de signaux de commande DC, des moyens de découplage peuvent être intégrés ou associés au commutateur.

Ainsi, on peut prévoir (comme cela est illustré sur la figure 6A) un ou plusieurs condensateurs de découplage 31, 33 connectés en série avec les éléments conducteur 2, 4 et configurés pour laisser passer le signal RF et bloquer des signaux DC issus des électrodes 11, 13, 24, 26 des moyens de chauffage et en particulier les signaux DC issus des électrodes 11, 13 du moyen de chauffage direct.

Afin de bloquer la transmission de signal RF vers les électrodes 11, 13 du moyen de chauffage direct on peut prévoir une ou plusieurs inductances 36, 37 de découplage en série avec les électrodes 11, 13 de chauffage direct (figure 6B).

Afin de bloquer une transmission de signal RF vers les électrodes 24, 26 du moyen de chauffage indirect, il est également possible de connecter une ou plusieurs inductance 38, 39 respectivement en série avec ces électrodes de chauffage 24,26 (figure 6C).

Un commutateur tel que décrit précédemment comporte un matériau PCM. Il est également possible, en variante, d'intégrer plusieurs matériaux différents et en particulier de prévoir des matériaux PCM différents d'une parcelle 7a, 7b, à l'autre de matériau PCM. On peut choisir en particulier des matériaux PCM avec des températures d'amorphisation différentes. Le moyen de chauffage des matériaux PCM peut dans ce cas être configuré de sorte à émettre un premier type d'impulsion de température pour laquelle tous les matériaux PCM sont dans un état cristallin avec une résistance globale faible. Le moyen de chauffage des matériaux PCM peut dans ce cas être configuré pour émettre un deuxième type d'impulsion de température de sorte qu'au moins un matériau PCM passe de l'état cristallin à l'état amorphe tandis qu'au moins un autre matériau PCM reste dans son état cristallin, afin d'obtenir une première valeur de résistance. Le moyen de chauffage des matériaux PCM peut dans ce cas être configuré de sorte à émettre un troisième type d'impulsion de température prévue en termes d'intensité et de durée de sorte à rendre amorphe l'ensemble des matériaux PCM. On peut ainsi mettre en oeuvre une zone de matériau PCM formant une résistance variable.

L'exemple de commutateur qui vient d'être donné sert à la transmission de signaux RF. Toutefois, la présente invention peut s'appliquer à la mise en oeuvre d'autres types de commutateurs utilisés pour transmettre d'autres types de signaux électriques, en particulier de type DC (continu), BF (basse fréquence), mmw (ondes millimétriques), térahertz.

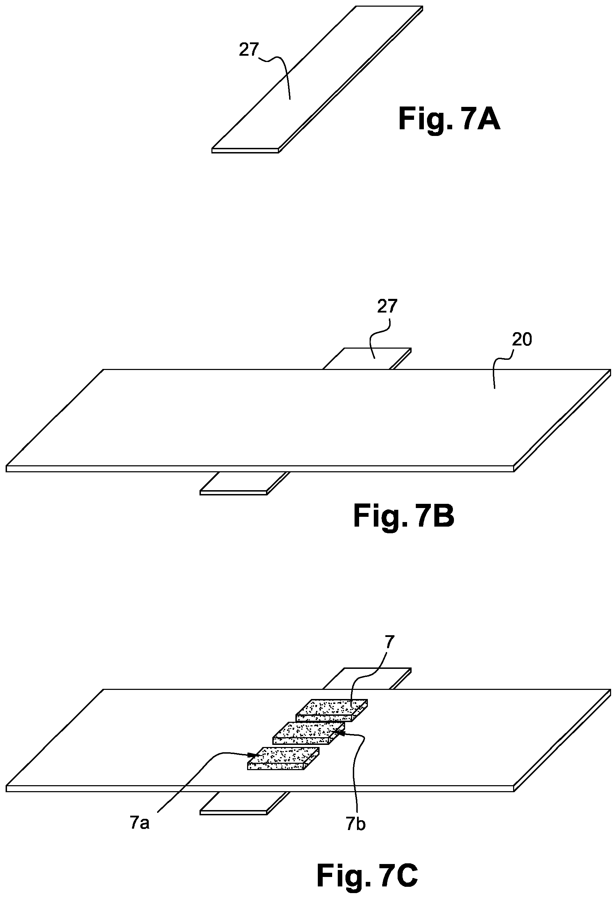

Un exemple de procédé de fabrication d'une structure de commutateur telle que décrite précédemment va à présent être donné en liaison avec les figures 7A-7F.

Le support de départ de ce procédé peut être un substrat, par exemple en silicium passivé par une couche de SiO₂ (dioxyde de silicium).

Sur ce support (non représenté sur les figures 7A-7F) on peut réaliser tout d'abord la résistance 27 du moyen de chauffage indirect (figure 7A). Cette résistance 27 peut être sous forme d'une couche de matériau conducteur résistif tel que par exemple du nitrure de titane (TiN) d'épaisseur par exemple de l'ordre de 50 nm. Le dépôt du matériau conducteur résistif peut être effectué par exemple par PVD (pour « Physical Vapor Deposition ») et être suivi de la réalisation d'un motif formé par exemple par photolithographie puis par gravure chimique.

Une première couche de matériau diélectrique 20 peut être ensuite formée (figure 7B) sur la résistance 27. Cette couche peut être par exemple en nitrure de silicium (SiN) et avoir une épaisseur par exemple de l'ordre de 100 nm. Le dépôt peut être réalisé par exemple par PECVD (pour « Plasma Enhanced Chemical Vapor Deposition ») et être suivi d'étapes de photolithographie et de gravure par exemple par RIE (pour « Reactive Ion Etching ») d'au moins un motif.

On dépose ensuite une couche de matériau à changement de phase 7, par exemple du GeTe ayant une épaisseur typiquement de l'ordre de 100 nm, dans laquelle on réalise plusieurs motifs en forme de parcelles ou de zones parallèles 7a, 7b, 7c distinctes reposant sur la couche de matériau diélectrique 20. Les zones parallèles 7a, 7b, 7c ont par exemple une forme rectangulaire. Les motifs sont réalisés par exemple par photolithographie puis gravure IBE (pour « Ion Beam Etching ») ou gravure RIE (figure 7C).

Un empilement de matériau conducteur électrique est ensuite déposé par exemple par PVD. L'empilement peut être formé d'une première couche métallique par exemple à base de W et d'épaisseur par exemple de l'ordre de 20 nm recouverte d'une deuxième couche métallique, par exemple à base d'Au et d'épaisseur de l'ordre de 1 µm.

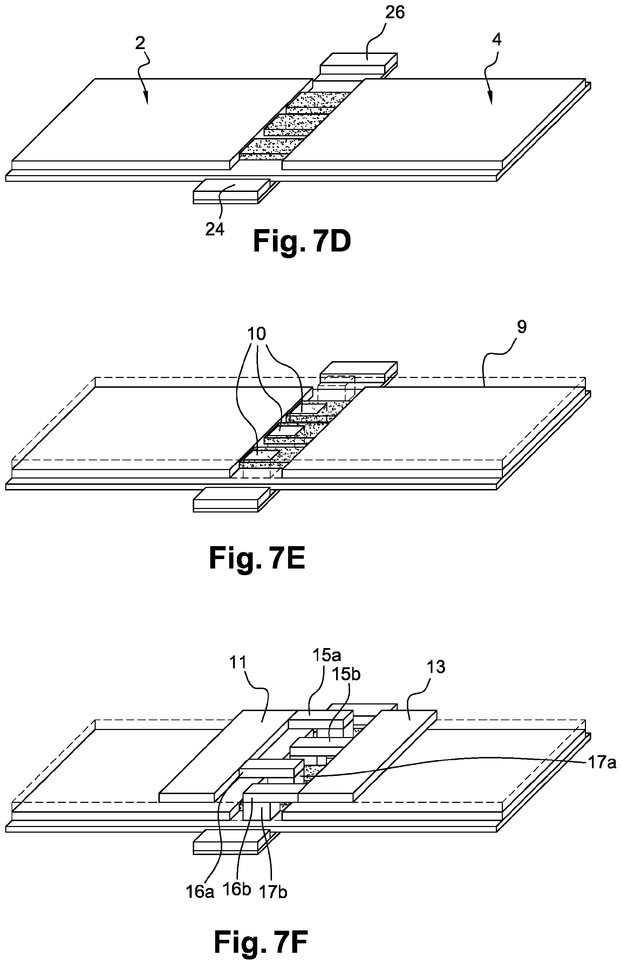

Des motifs correspondants au premier élément conducteur 2 et au deuxième élément conducteur 4, par lesquels le signal RF est destiné respectivement à entrer puis à sortir sont alors formés de part et d'autre des zones 7a, 7b, 7c de matériau à changement de phase 7. Dans cet empilement, d'autres motifs correspondant aux électrodes 24, 26 de chauffage indirect peuvent également être réalisés par gravure chimique successive de la couche d'Au et de W (figure 7D). Ces autres motifs sont pratiqués sur des portions de l'empilement qui reposent sur la résistance 27 et s'étendent dans des trous réalisés préalablement dans la couche de matériau diélectrique 20.

Puis, une autre couche de matériau diélectrique 9 est déposée, par exemple par PECVD (« Plasma Enhanced Chemical Vapor deposition ») de 100 nm de SiN (figure 7E). Des ouvertures 10 sont ensuite formées dans cette autre couche de matériau diélectrique 9 entre les zones ou parcelles de matériau 7 PCM, par exemple par gravure par RIE. Cette étape est réalisée par photolithographie de telle sorte que les bords des ouvertures soient en contact avec les zones ou parcelles de matériau 7 PCM.

Un empilement de matériau conducteur électrique est ensuite déposé, par exemple par PVD, de sorte à remplir les ouvertures et à recouvrir la couche de matériau diélectrique 9. Cet empilement peut être formé d'une couche métallique par exemple à base de W et d'épaisseur de l'ordre de 20 nm et d'une autre d'une couche métallique par exemple à base d'Au et de l'ordre de 1 µm.

On réalise alors dans cet empilement des motifs correspondants aux électrodes 11, 13 de chauffage direct dotés de portions conductrices 15 interdigitées. Ces motifs sont réalisés par gravure chimique successives des couches d'Au et de W (figure 7F).

## Revendications

1. Dispositif apte à acheminer ou à interrompre une connexion entre au moins un premier élément conducteur (2) et au moins un deuxième élément conducteur (4) reposant sur un support, ledit dispositif comprenant :
- au moins un matériau à changement de phase (7) disposé entre le premier élément conducteur (2) et le deuxième élément conducteur (4), le matériau à changement de phase étant apte à changer d'état entre un état cristallin dans lequel le matériau à changement de phase a une première résistivité et un état amorphe dans lequel le matériau à changement de phase a une deuxième résistivité plus importante que la première résistivité, de telle sorte que lorsque le matériau à changement de phase est dans l'état cristallin il permet l'acheminement d'un premier signal entre le premier élément conducteur et le deuxième élément conducteur, lorsque le matériau à changement de phase est dans l'état amorphe il empêche l'acheminement du premier signal entre le premier élément conducteur et le deuxième élément conducteur,
- des moyens de chauffage (11, 13, 24, 26, 27) du matériau à changement de phase dotés d'au moins une première électrode (11) et d'au moins une deuxième électrode (13), les moyens de chauffage étant aptes à modifier l'état du matériau à changement de phase (7) par effet Joule en injectant au moins un signal électrique d'activation entre la première électrode et la deuxième électrode,
le dispositif étant **caractérisé en ce qu'**il comporte, entre le premier élément conducteur (2) et le deuxième élément conducteur (4) :
- au moins une première zone (7a) de matériau à changement de phase et une au moins une deuxième zone (7b) de matériau à changement de phase, la première zone (7a) de matériau à changement de phase et la deuxième zone (7b) de matériau à changement de phase étant disposées de part et d'autre et en contact d'une portion conductrice d'une électrode donnée parmi lesdites première électrode et deuxième électrode, la première zone (7a) de matériau à changement de phase étant intercalée entre ladite portion conductrice de l'électrode donnée et une portion conductrice d'une autre électrode parmi lesdites première électrode et deuxième électrode, la deuxième zone (7b) de matériau à changement de phase étant intercalée entre ladite portion conductrice de l'électrode donnée et une portion conductrice d'une autre électrode parmi lesdites première électrode et deuxième électrode.

2. Dispositif selon la revendication 1, dans lequel la première électrode (11) comporte une pluralité de portions conductrices (17a) et la deuxième électrode (13) comporte une pluralité de portions conductrices (17b), les portions conductrices de la première électrode et les portions conductrices de la deuxième électrode étant interdigitées.

3. Dispositif selon l'une des revendications 1 ou 2, dans lequel lesdites portions conductrices (17a, 17b) sont agencées orthogonalement au plan principal du support.

4. Dispositif selon l'une des revendications 1 à 3, dans lequel le premier élément conducteur (2) et le deuxième élément conducteur (4) sont disposées dans un même premier plan parallèle au plan principal du support.

5. Dispositif selon l'une des revendications 1 à 4, dans lequel lesdites portions(s) conductrices (17a, 17b) sont reliées à une zone conductrice (16a, 16b, 14) disposée dans un plan distinct du premier plan et parallèle audit premier plan.

6. Dispositif selon l'une des revendications 1 à 5, dans lequel la première zone (7a) de matériau à changement de phase et la deuxième zone (7b) de matériau à changement de phase ont une longueur L' mesurée selon un axe passant par les éléments conducteurs et une largeur W' mesurée selon un axe orthogonal aux éléments conducteurs telles que L'/W' supérieur à 1 et de préférence supérieur à 3.

7. Dispositif selon l'une des revendications 1 à 6, dans lequel le premier élément conducteur (2) et/ou le deuxième élément conducteur (4) est connecté électriquement à un premier moyen de découplage entre le premier signal et le signal électrique d'activation tel qu'un condensateur de découplage (31, 33).

8. Dispositif selon l'une des revendications 1 à 7, dans lequel la première électrode (11) et/ou la deuxième électrode (13) est connectée à un deuxième moyen de découplage entre le signal électrique d'activation et le premier signal telle qu'une inductance de découplage (36, 37).

9. Dispositif selon l'une des revendications 1 à 8, dans lequel la première électrode (11) et la deuxième électrode (13) sont en contact avec le matériau à changement de phase (7) et forment un moyen de chauffage direct du matériau à changement de phase, les moyens de chauffage comprenant en outre au moins un moyen de chauffage indirect (24, 26) du matériau à changement de phase, le moyen de chauffage indirect étant configuré pour chauffer le matériau à changement de phase par radiation thermique.

10. Dispositif selon la revendication 9, dans lequel le premier élément conducteur (2) et le deuxième élément conducteur (4) sont disposés dans au moins un premier plan et dans lequel le moyen de chauffage indirect comprend une résistance (27) connectée à au moins une électrode supplémentaire (24, 26) par laquelle un autre signal électrique d'activation est destiné à être appliqué, l'électrode supplémentaire (24, 26) étant disposée avantageusement dans le premier plan.

11. Dispositif selon la revendication 10, dans lequel l'électrode supplémentaire (24, 26) est connectée à un moyen de découplage entre ledit autre signal d'activation et le premier signal tel qu'une inductance de découplage (38, 39).

12. Dispositif selon l'une des revendications 9 à 11, dans lequel les moyens de chauffage comprennent des moyens de commande configurés pour, alternativement :
- injecter le signal électrique d'activation à l'électrode donnée (11, 13) de sorte à faire passer au moins une zone de matériau à changement de phase d'un état cristallin à un état amorphe,
- injecter le signal électrique d'activation à l'électrode supplémentaire (24, 26) de sorte à faire passer au moins une zone de matériau à changement de phase d'un état amorphe à un état cristallin,
ou bien lesdits moyens de commande sont configurés pour injecter le signal électrique d'activation à l'électrode donnée (11, 13) et injecter concomitamment l'autre signal d'activation à l'électrode supplémentaire (24, 26).

13. Dispositif selon l'une des revendications 1 à 12, dans lequel le matériau à changement de phase est à base de chalcogénure ou d'un alliage de chalcogénures.

14. Dispositif selon l'une des revendications 1 à 13, comportant au moins deux zones de matériaux à changement de phase différents entre le premier élément conducteur (2) et le deuxième élément conducteur (4).

15. Commutateur RF ou interrupteur RF formé d'un dispositif selon l'une des revendications 1 à 14, le signal apte à être acheminé entre le premier élément conducteur (2) et le deuxième élément conducteur (4) étant un signal RF.

## Patentansprüche

1. Vorrichtung zum Herstellen oder zum Unterbrechen einer Verbindung zwischen wenigstens einem ersten Leiterelement (2) und wenigstens einem zweiten Leiterelement (4), das auf einem Träger ruht, wobei die Vorrichtung umfasst:
- wenigstens ein Phasenänderungsmaterial (7), das zwischen dem ersten Leiterelement (2) und dem zweiten Leiterelement (4) angeordnet ist, wobei das Phasenänderungsmaterial dazu ausgelegt ist, seinen Zustand zwischen einem kristallinen Zustand, in dem das Phasenänderungsmaterial einen ersten Widerstand hat, und einem amorphen Zustand zu ändern, in dem das Phasenänderungsmaterial einen zweiten Widerstand hat, der größer als der erste Widerstand ist, derart, dass wenn das Phasenänderungsmaterial im kristallinen Zustand ist, es die Leitung eines ersten Signals zwischen dem ersten Leiterelement und dem zweiten Leiterelement erlaubt, und wenn das Phasenänderungsmaterial im amorphen Zustand ist, es die Leitung des ersten Signals zwischen dem ersten Leiterelement und dem zweiten Leiterelement verhindert,
- Mittel (11, 13, 24, 26, 27) zum Heizen des Phasenänderungsmaterials, die mit wenigstens einer ersten Elektrode (11) und wenigstens einer zweiten Elektrode (13) ausgestattet sind, wobei die Heizmittel dazu ausgelegt sind, den Zustand des Phasenänderungsmaterials (7) durch Joule-Effekt zu modifizieren, indem wenigstens ein elektrisches Aktivierungssignal zwischen die erste Elektrode und die zweite Elektrode injiziert wird,
wobei die Vorrichtung **dadurch gekennzeichnet ist, dass** sie zwischen dem ersten Leiterelement (2) und dem zweiten Leiterelement (4) Folgendes umfasst:
- wenigstens eine erste Zone (7a) des Phasenänderungsmaterials und wenigstens eine zweite Zone (7b) des Phasenänderungsmaterials, wobei die erste Zone (7a) des Phasenänderungsmaterials und die zweite Zone (7b) des Phasenänderungsmaterials auf beiden Seiten eines leitenden Bereichs einer gegebenen Elektrode aus der ersten Elektrode und der zweiten Elektrode angeordnet und hiermit in Kontakt sind, wobei die erste Zone (7a) des Phasenänderungsmaterials zwischen dem leitenden Bereich der gegebenen Elektrode und einem leitenden Bereich einer anderen Elektrode aus der ersten Elektrode und der zweiten Elektrode eingefügt ist, wobei die zweite Zone (7b) des Phasenänderungsmaterials zwischen dem leitenden Bereich der gegebenen Elektrode und einem leitenden Bereich einer anderen Elektrode aus der ersten Elektrode und der zweiten Elektrode eingefügt ist.

2. Vorrichtung nach Anspruch 1, bei der die erste Elektrode (11) eine Mehrzahl von leitenden Bereichen (17a) umfasst, und die zweite Elektrode (13) eine Mehrzahl von leitenden Bereichen (17b) umfasst, wobei die leitenden Bereiche der ersten Elektrode und die leitenden Bereiche der zweiten Elektrode interdigital sind.

3. Vorrichtung nach einem der Ansprüche 1 oder 2, bei der die leitenden Bereiche (17a, 17b) orthogonal zur Hauptebene des Trägers angeordnet sind.

4. Vorrichtung nach einem der Ansprüche 1 bis 3, bei der das erste Leiterelement (2) und das zweite Leiterelement (4) in ein und derselben ersten Ebene parallel zur Hauptebene des Trägers angeordnet sind.

5. Vorrichtung nach einem der Ansprüche 1 bis 4, bei der die leitenden Bereich(e) (17a, 17b) mit einer leitenden Zone (16a, 16b, 14) verbunden sind, die in einer Ebene angeordnet ist, welche von der ersten Ebene verschieden und parallel zur ersten Ebene ist.

6. Vorrichtung nach einem der Ansprüche 1 bis 5, bei der die erste Zone (7a) des Phasenänderungsmaterials und die zweite Zone (7b) des Phasenänderungsmaterials eine Länge L' haben, gemessen entlang einer Achse, die durch die Leiterelemente verläuft, sowie eine Breite W' gemessen entlang einer Achse orthogonal zu den Leiterelementen, derart, dass L'/W' größer als 1 und vorzugsweise größer als 3 ist.

7. Vorrichtung nach einem der Ansprüche 1 bis 6, bei der das erste Leiterelement (2) und/oder das zweite Leiterelement (4) elektrisch an eine erste Einrichtung zur Entkopplung zwischen dem ersten Signal und dem elektrischen Aktivierungssignal angeschlossen ist, beispielsweise einen Entkopplungskondensator (31, 33).

8. Vorrichtung nach einem der Ansprüche 1 bis 7, bei der die erste Elektrode (11) und/oder die zweite Elektrode (13) an eine zweite Einrichtung zur Entkopplung zwischen dem elektrischen Aktivierungssignal und dem ersten Signal angeschlossen ist, beispielsweise eine Entkopplungsinduktanz (36, 37).

9. Vorrichtung nach einem der Ansprüche 1 bis 8, bei der die erste Elektrode (11) und die zweite Elektrode (13) in Kontakt mit dem Phasenänderungsmaterial (7) sind und ein Mittel zum direkten Heizen des Phasenänderungsmaterials bilden, wobei die Heizmittel ferner wenigstens ein Mittel (24, 26) zum indirekten Heizen des Phasenänderungsmaterials umfassen, wobei das indirekte Heizmittel dazu ausgelegt ist, das Phasenänderungsmaterial durch thermische Strahlung zu heizen.

10. Vorrichtung nach Anspruch 9, bei der das erste Leiterelement (2) und das zweite Leiterelement (4) wenigstens in einer ersten Ebene angeordnet sind, und bei der das indirekte Heizmittel einen Widerstand (27) umfasst, der an wenigstens eine zusätzliche Elektrode (24, 26) angeschlossen ist, durch die ein anderes elektrisches Aktivierungssignal angelegt werden soll, wobei die zusätzliche Elektrode (24, 26) vorzugsweise in der ersten Ebene angeordnet ist.

11. Vorrichtung nach Anspruch 10, bei der die zusätzliche Elektrode (24, 26) an eine Einrichtung zur Entkopplung zwischen dem anderen Aktivierungssignal und dem ersten Signal angeschlossen ist, beispielsweise eine Entkopplungsinduktanz (38, 39).

12. Vorrichtung nach einem der Ansprüche 9 bis 11, bei der die Heizmittel Steuerungsmittel umfassen, die zu folgenden alternativen Schritten ausgelegt sind:
- Injizieren des elektrischen Aktivierungssignals an der gegebenen Elektrode (11, 13) derart, dass wenigstens eine Zone des Phasenänderungsmaterials von einem kristallinen Zustand in einen amorphen Zustand übergeht,
- Injizieren des elektrischen Aktivierungssignals an der zusätzlichen Elektrode (24, 26) derart, dass wenigstens eine Zone des Phasenänderungsmaterials von einem amorphen Zustand in einen kristallinen Zustand übergeht,
oder aber wobei die Steuermittel dazu ausgelegt sind, das elektrische Aktivierungssignal an der gegebenen Elektrode (11, 13) zu injizieren, und gleichzeitig das andere Aktivierungssignal an der zusätzlichen Elektrode (24, 26) zu injizieren.

13. Vorrichtung nach einem der Ansprüche 1 bis 12, bei der das Phasenänderungsmaterial auf Basis von Chalkogenid oder einer Chalkogenidlegierung ist.

14. Vorrichtung nach einem der Ansprüche 1 bis 13, umfassend wenigstens zwei Zonen von unterschiedlichen Phasenänderungsmaterialien zwischen dem ersten Leiterelement (2) und dem zweiten Leiterelement (4).

15. RF-Schalter oder RF-Unterbrecher, der mit einer Vorrichtung nach einem der Ansprüche 1 bis 14 gebildet ist, wobei das Signal, das dazu ausgelegt ist, zwischen dem ersten Leiterelement (2) und dem zweiten Leiterelement (4) geleitet zu werden, ein RF-Signal ist.

## Claims

1. Device capable of routing or interrupting a connection between at least one first conducting element (2) and at least one second conducting element (4) resting on a support, said device including:
- at least one phase change material (7) arranged between the first conducting element (2) and the second conducting element (4), the phase change material being capable of changing state between a crystalline state wherein the phase change material has a first resistivity and an amorphous state wherein the phase change material has a second resistivity higher than the first resistivity, in such a way that when the phase change material is in the crystalline state it enables the routing of a first signal between the first conducting element and the second conducting element, when the phase change material is in the amorphous state it prevents the routing of the first signal between the first conducting element and the second conducting element,
- heating means (11, 13, 24, 26, 27) to heat the phase change material provided with at least one first electrode (11) and at least one second electrode (13), the heater being capable of modifying the state of the phase change material (7) by Joule effect by injecting at least one electrical activation signal between the first electrode and the second electrode,
The device being **characterized in that** it comprises between first conducting element (2) and the second conducting element (4):
- at least one first zone (7a) of phase change material and at least one second zone (7b), the first zone (7a) of phase change material and the second zone (7b) of phase change material being arranged on either side and in contact with a conducting portion of a given electrode among said first electrode and second electrode, the first zone (7a) of phase change material being intercalated between said conducting portion of the given electrode and a conducting portion of another electrode among said first electrode and second electrode, the second zone (7b) of phase change material being intercalated between said conducting portion of the given electrode and a conducting portion of another electrode among said first electrode and second electrode.

2. Device according to claim 1, wherein the first electrode (11) comprises a plurality of conducting portions (17a) and the second electrode (13) comprises a plurality of conducting portions (17b), the conducting portions of the first electrode and the conducting portions of the second electrode being interdigitated.

3. Device according to any of the claims 1 or 2, wherein said conducting portions (17a, 17b) are laid out orthogonally to the main plane of the support.

4. Device according to any of the claims 1 to 3, wherein the first conducting element (2) and the second conducting element (4) are arranged in a same first plane parallel to the main plane of the support.

5. Device according to any of the claims 1 to 4, wherein said conducting portion(s) (17a, 17b) are connected to a conducting zone (16a, 16b, 14) arranged in a plane separate from the first plane and parallel to said first plane.

6. Device according to any of the claims 1 to 5, wherein the first zone (7a) of phase change material and the second zone (7b) of phase change material have a length L' measured along an axis passing through the conducting elements and a width W' measured along an axis orthogonal to the conducting elements such that L'/W' is greater than 1 and preferably greater than 3.

7. Device according to any of the claims 1 to 6, wherein the first conducting element (2) and/or the second conducting element (4) is electrically connected to a first decoupler between the first signal and the electrical activation signal, such as a decoupling capacitor (31, 33).

8. Device according to any of the claims 1 to 7, wherein the first electrode (11) and/or the second electrode (13) is connected to a second decoupler between the electrical activation signal and the first signal, such as a decoupling inductance (36, 37).

9. Device according to any of the claims 1 to 8, wherein the first electrode (11) and the second electrode (13) are in contact with the phase change material (7) and form a direct heater of the phase change material, the heater further including at least one indirect heater (24, 26) of the phase change material, the indirect heater being configured to heat the phase change material by heat radiation.

10. Device according to claim 9, wherein the first conducting element (2) and the second conducting element (4) are arranged in at least one first plane and wherein the indirect heater includes a resistance (27) connected to at least one additional electrode (24, 26) through which another electrical activation signal is intended to be applied, the additional electrode (24, 26) advantageously being arranged in the first plane.

11. Device according to claim 10, wherein the additional electrode (24, 26) is connected to a decoupler between said other activation signal and the first signal, such as a decoupling inductance (38, 39).

12. Device according to any of the claims 9 to 11, wherein the heater is controlled to alternatively:
- inject the electrical activation signal to the given electrode (11, 13) so as to make at least one zone of phase change material change from a crystalline state to an amorphous state,
- inject the electrical activation signal to the additional electrode (24, 26) so as to make at least one zone of phase change material change from an amorphous state to a crystalline state,
or the control means are configured to inject the electrical activation signal to the given electrode (11, 13) and concomitantly to inject the other activation signal to the additional electrode (24, 26).

13. Device according to any of the claims 1 to 12, wherein the phase change material is based on chalcogenide or an alloy of chalcogenides.

14. Device according to any of the claims 1 to 13, comprising at least two zones of different phase change materials between the first conducting element (2) and the second conducting element (4).

15. RF commutator or RF switch formed of a device according to any of the claims 1 to 14, the signal capable of being routed between the first conducting element (2) and the second conducting element (4) being a RF signal.
